(19) Europäisches Patentamt
European Patent Office
Office européen des brevets

(11) Publication number: 0 505 654 A1

# (12) EUROPEAN PATENT APPLICATION

(21) Application number: 91480054.5

(51) Int. Cl.5: H03M 7/30

(22) Date of filing: 29.03.91

(43) Date of publication of application:
30.09.92 Bulletin 92/40

(84) Designated Contracting States:
DE FR GB

(71) Applicant: INTERNATIONAL BUSINESS MACHINES CORPORATION

Armonk, NY 10504(US)

(72) Inventor: Goubault, Eric
175, rue de Javel
F-75015 Paris(FR)
Inventor: Lancon, Emmanuel
Zeltweg, 57
CH-8032 Zurich(FR)
Inventor: Menez, Jean
43, ch. du Lautin - "le Manet"
F-06800 Cagnes sur Mer(FR)
Inventor: Raimondo, Cathy
12 (bis) allée de Colle Longue, "Les Englades"
F-06270 Villeneuve Loubet(FR)

(74) Representative: Tubiana, Max
Compagnie IBM France Département de Propriété Intellectuelle
F-06610 La Gaude(FR)

## (54) Vector quantizing method for coding signals and system for implementing said method.

(57) Signal samples to be coded using vector quantizing means are deserialized into a vector X. A codebook (22) includes codewords reordered according to their distances relative to a predefined reference vector Vref. Then each vector X is first processed into a logic (24) computing the distance d of X relative to Vref ; d is used to locate $C_i$ and $C_{i+1}$ the distances of which relative to Vref are closest to d. Finally, triangular inaquality tests are used to detect the codewords left of $C_i$ and right of $C_{i+1}$, closest to X, and the still closest is selected as codeword for quantizing X among those detected left and right codewords.

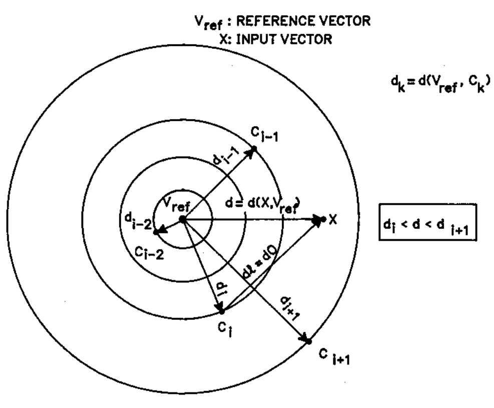


FIG.2



Rank Xerox (UK) Business Services

## Field of invention

This invention relates to a method and system for performing signal coding and data compression based on vector quantizing techniques, which optimize system performance with substantially reduced computational complexity.

## Background of invention

Methods for data compression/coding based on vector quantizing techniques are known to be very efficient in terms of data compression. Unfortunately, said methods involve a rather important computational complexity inherent to the very principles of vector quantizing.

Said methods are however of increasing interest to developing modern networks and multimedia communication systems wherein several kinds of data (e.g. digitally represented audio and video signals) are to be indistinctally processed.

The principles of vector quantizing involve grouping a predefined number (N) of signal samples into a vector and comparing each current signal vector (X) to a limited number of vectors (codewords) prestored into a dictionary (codebook) representative of the kind of signal to be coded. The size of the dictionary depends on the number of bits to encode each X vector. Compression is achieved by replacing each X vector by the address of the codeword "C" (coding vector) which best matches said X vector.

By best matching, one must understand : leading to a minimal quantizing error (maximum SNR), by being the closest in terms of Euclidian distances.

To that end, the straightforward scheme would involve full search throughout the codebook for each current X vector to be processed. The larger the codebook, the larger the number of bits per vector, the better the quality, but the higher the number of required comparisons between X and C's, and therefore the higher the computational complexity.

Different techniques such as "tree search" or "Multi-step" Vector-Quantizing provide a lower complexity by reducing the number of overall required comparisons. But those approaches are sub-optimal with respect to full search.

## Summary of the invention

One object of the invention is to provide a vector quantizing method enabling reducing the operating complexity while keeping most of the full search advantages, through so called reordering operations with respect to a preselected reference vector, and use of pre-computed data thus limiting the number of recomputing operations for each vector to be quantized.

Another object is to provide a vector quantizing method for coding a sampled signal represented by input vectors each vector including a predefined number (N) of signal samples, said coding involving converting any current signal vector into a codebook address pointing at a so-called nearest vector (codeword) (Ci) stored into said codebook, said method being characterized in that it includes :

- preprocessing for reordering said codebook, said preprocessing including :
  - . defining a reference vector (Vref) ;
  - . computing the Euclidian distance of each codebook vector with respect to Vref and deriving therefrom, so-called distances (di) ;
  - . ordering said computed distances (di) according to their relative values, into a so-called distance table ;
  - . reordering said codebook according to said distance table ;
- coding each current vector (X), said coding including :
  - . computing the distance (d) of said current signal vector relative to said reference vector ;
  - . searching into said distance table the closest distance to said computed current vector distance (d), and deriving therefrom the corresponding reordered codebook address of the closest vector therein, based on so-called triangular inequality test.

Further objects, characteristics and advantages of this invention will be explained in more details in the following, with reference to the enclosed drawings which represent a preferred embodiment thereof.

## Brief description of the drawings

Figure 1 is a block diagram of a coder for implementing the invention.

Figure 2 illustrates the invention for 2 dimensional spaced vectors

Figures 3 and 3A are flow-charts for implementing a first step of the invention.
Figures 4 through 5A are flow-charts for implementing remaining step(s).
Figures 6 and 7 are flow charts for implementing a simplified method.

## Detailed description of the preferred embodiment

Vector quantizing techniques have been extensively applied within various signal coders. One may for instance refer to European Patent Application n° 88480006.1-2215/, wherein vector quantizing operations are operated over a so-called error signal derived through preprocessing operations, from an input speech signal. In this case the so called X vector would comprise consecutive error signal samples. It should however already be noted, and that will become more readily noticeable from the following description, that the present invention would also apply directly to input speech samples or any audio signal (both being herein referenced to as audio signal), as well as be applied to video (including image) signals (e.g. luminance signal) or any other temporally or spatially varying video signal. In the latter cases the vector X would include consecutive pixels.

As far as the present invention is concerned, the significant coder section may be represented as shown in the block diagram of figure 1. Digitally expressed signal samples $x_1$, $x_2$, $x_3$,...,$x_i$.... are fed into a deserializer (10) wherein they are grouped into N-dimensional vectors X, each including N consecutive or non-consecutive samples:

$$X = (x_1, x_2, x_3, ..., x_N)$$

Each current vector X is then fed into a quantizing device (20) including a codebook with addressing means (22) and logic means (24).

Said codebook includes stored codewords:

$$C'1 = (y_1, y_2, y_3, ..., y_N)$$

$$C'2 = (y_{N+1}, .........., y_{2N})$$

.

.

$$C'i = (y_{(i-1)N+1}, ......., y_{iN})$$

.

.

$$C'S = (................, y_{SN})$$

The logic device, which obviously in a microprocessor or signal processor implemented system would mainly include a microprogram plus timing and sequencing means, should also include logic to perform the reordering and comparing operations of the invention. Said reordering is performed with respect to a predefined reference vector.

Let Vref be a preselected reference vector

$$V = (v_1, v_2, v_3, ..., v_N)$$

Let S be the size of the codebook, i.e. the number of codewords recorded therein. One should first reorder the codebook relative to Vref. This could be achieved through preprocessing operations which might be performed off-line. To that end, the logic (or corresponding program) controls should first compute the Euclidian distance of each codeword with respect to Vref and derive therefrom

$$d'_j = D(C'_j, Vref) = (\sum_{k=1}^{N}(y_k - V_k)^2)^{1/2}$$

for j = 1, 2, ..., S.

These operations provide a set of S distance values which are reordered according to their relative values i.e. in increasing order, and stored into a so-called distance table T.

$T = \{d_1, d_2, d_3, ..., d_S\}$

Wherein $d_1 < d_2 < d_3 < ... < d_S$ are the computed distances d' ordered in an increasing order.

The codebook is then reordered according to said distance table, i.e. the codewords are ordered with respect to their relative distance to Vref, the closest first, then the second closest, and so on.

Once the codeword vectors are reordered into a reordered codebook, their indexes refer to their reordered position (the smaller the index, the closer to Vref the codeword vector). In other words, said reordered codebook includes the original codewords stored in a different order. To denote said reordering, the reordered codewords are referred to as $C_1$, $C_2$, ...., $C_i$, ...., $C_S$.

Figure 2 illustrates the above distances versus Vref in a two-dimensional space.

Also illustrated in figure 2 is the first step for quantizing a current vector X, through:

- computing the distance of X relative to Vref:

$$d = D(X, Vref) = (\sum_{k=1}^{N}(x_k - V_k)^2)^{1/2}$$

One should note that Vref could be selected for being the vector reference origin, in which case, $v_1 = v_2 = ..... = v_n = 0$. Any codeword vector distance relative to Vref would then be made equal to the vector length. This should simplify the vector distances computations, but is not a must. In fact, better results would be obtained if Vref is selected with $v_1 = v_2 = ..... = v_n = Vmax$, wherein Vmax is the maximum numerical value allowable by the system being used.

- searching into the ordered distance table (T) the closest distances to d:

As illustrated in figure 2

$d_i < d < d_{i+1}$

Which leads to locating the current vector as:

$$\begin{array}{ccccc} D(C_i, Vref) & < & D(X, Vref) & < & D(C_{i+1}, Vref) \\ d_i & < & d & < & d_{i+1} \end{array}$$

One needs then deriving therefrom, the corresponding reordered codebook address of the closest vector therein, based on searches left of $d_i$ and right of $d_{i+1}$ and on so-called triangular equality tests.

Represented in figure 3 is a flow-chart for achieving the dichotomous determination of "i" leading to $d_i < d < d_{i+1}$ for a given current vector X. In other words, the operations performed lead to locating "d" relative to the distance table, or searching into said distance table for the closest distance to d.

Given such a flow-chart, a man skilled in the art will have no trouble writing a program , without undue effort, in any convenient programming language. Said language would also take into consideration the signal processor which would be selected to implement the invention. One should also note here, that the above comments on transcription into programs will apply to all subsequent flow-charts described in this application.

The corresponding programs are stored into the LOGIC section of device (20) to control the following

operations.

Let j and l be the beginning and ending codebook computing indexes, respectively. Start with setting l = S and j = 1 and compute a current i index as represented in (31). Read current corresponding $d_i$ value into the table (T) and compare $d_i$ to d to test whether $d_i$<d or $d_i$ = d (see test 32). In case of positive test, set j = i, which should lead to searching on the right side of i (i.e. by increasing i values). Otherwise, should the test be negative, then set l = i. In both instances, check whether the current indexes l and i are consecutive (see test 33). If they are not,, then go back to step (31) and resume the whole dichothomic test operations. Otherwise, the index i is the one looked for, which should identify $d_i$ and therefore $d_{i+1}$.

Boundaries considerations are taken into account through the operations represented in figure 3A. A lower limit test is first performed through testing whether j = 1. If not, then d is located between $d_1$ and $d_2$. Otherwise, i is set to zero which prevents from entering into subsequent left searches. A test (l = S?) or upper limit test is then performed. In case of negative answer, d<$d_S$. Otherwise, subsequent checking (34) is performed, which, upon detecting that d>$d_S$, enables preventing from entering into so-called right searches, through forcing i = l.

The triangular inequality test is now to be started on both left of $d_i$ and right of $d_{i+1}$, or limited to one side, based on the conclusions provided by the operations of figure 3A.

Represented in figure 4 is a flow-chart for performing the searching operations on the left of i. An index $\ell$, ($\ell$ standing for left) used to track the current search displacement relative to i, is initialized to $\ell$ = 0. Let "old_d$\ell$" be a parameter defining the minimum distance between the vector to be coded and the ordered codebook vector old_$\ell$ steps to the left of $C_i$. Let old_d$\ell$ be set to a predefined maximum value, e.g. old_d$\ell$ is initialized to 1000. A flag is also used to define the condition wherein the left search operations are to be stopped. For instance the flag = 0 should initiate a stop. Said flag is initialized to flag = 1. The left test per se mainly consists in two tests: the first test looks for the immediate closest vector to X and on the left of index i, through a step-by-step process whereby $\ell$ is incremented by one unit after each processing step. the second test resolves a triangular inequality which enables guessing whether an even closer vector could be located, in which case, the left test operations are resumed.

Otherwise, the process stops (flag = 0) and $d_{i-\ell}$ is detected. More particularly, for left search considerations, the distance between the current vector (X) and the $\ell$th vector on the left of vector $C_i$ is first computed (42). Then test (44) tests whether d$\ell$ is smaller or equal to the last buffered codeword (old_d$\ell$). Should this condition be verified, then old_d$\ell$ = d$\ell$ and old_$\ell$ = $\ell$ are buffered, and then the left search operations switch to the second step, i.e. triangular inequality test. Otherwise, the triangular inequality operations are performed directly after the test (44).

It should be noted that Old_d$\ell$ and Old_$\ell$ are also, in practice, memory locations where the value of $\ell$, which gives the minimum value of d$\ell$ and said d$\ell$ are respectively stored.

The triangular inequality left test (46) consists in looking for

Old_d$\ell$ + $d_{i-\ell-1}$ < d

As long as this test is not verified the whole left search is repeated with $\ell$ being incremented by one unit at each retry. Once said test (46) is verified, then left search is stopped and the left closest codeword $C_{i-\ Old_\ell}$ address is buffered into said LOGIC device (see figure 1).

Assuming however, the left search has reached its limit with the flag = 1, this means that no codeword C verifying the triangular inequality (6) has been detected. One still needs testing for i = $\ell$ or first codebook index. Then the left search needs be completed according to the flow-chart of figure 4A. The distance d$\ell$ = d(X, C1) is computed and d$\ell$ is tested versus old_d$\ell$. Should old_d$\ell$ be smaller than d$\ell$, the process then exits and the values old_d$\ell$ and old_$\ell$ are stored. Otherwise, old_d$\ell$ is set equal to d$\ell$ and old_$\ell$ is set to (i-1) prior to exiting.

Searches to the right of codeword located at the address i in the reordered codebook could start.

Represented in figure 5 is a flow-chart for the so-called right search algorithm. An r (r standing for right) index is used to track the right displacement relative to index (i + 1). Index r is initialized to zero. Another index (old_dr) initialized to old_d$\ell$ is used to track the search displacement. A flag, initialized to one is also used to indicate the search stopping condition (flag = 0). And S refers to the codebook length. The right search algorithm looks similar to the left search except that the right distance (dr) is now computed with respect to $C_{(i+1)+r}$ as represented in (52), and the triangular inequality involves now:

Old_dr + d < $d_{(i+1)+(r+1)}$

Again limit conditions should be dealt with if no vector checking the triangular inequality test was located

during right search tests. One exited with (i + 1) + r = (S-1), which means unsuccessful right searches for all codewords right of (i + 1). Right limit searches are then performed according to the flow-chart of figure 5A. The distance dr = d(X, $C_S$) is first computed and then compared to old__dr. Depending whether dr is greater than old__dr or not, exiting conditions are direct or involve setting old__dr = dr and old__r = S-i-1 first.

Finally, the coding vector is selected between one on the left side and the other on the right side. The selected vector is either

$C_{i\text{-old}\ell}$ or $C_{i+1+\text{old_r}}$

whichever is closest to X. The current vector X is therefore vector quantized and the address of either $C_{i\text{-Old_}\ell}$ or $C_{i+1+\text{old_r}}$ (whichever was selected) is fed as the quantizer (20) output).

Obviously, left and right triangular tests could be performed starting with one or the other, without imparting on the gist of the invention.

A simplified method and system may also be used by simply limiting the above mentioned left and right searches to predefined limits designated by Lmax and Rma respectively. The corresponding flowcharts are represented in figures 6 and 7 which differ from figures 4 and 5 respectively by merely adding the ($\ell$ < Lmax ?) and (r < Rmax ?) tests.

## Claims

1. A vector quantizing method for coding a sampled signal represented by input vectors each vector including a predefined number (N) of signal samples, said coding involving converting any current signal vector into a codebook address pointing at a so-called nearest vector (codeword) ($C_i$) stored into said codebook, said method being characterized in that it includes :
   - preprocessing for reordering said codebook, said preprocessing including :
     . defining a reference vector (Vref) ;
     . computing the Euclidian distance of each codebook vector with respect to Vref and deriving therefrom, so-called distances ($d_i$) ;
     . ordering said computed distances ($d_i$) according to their relative values, into a so-called distance table ;
     . reordering said codebook according to said distance table ;
   - coding each current vector (X), said coding including :
     . computing the distance (d) of said current signal vector relative to said reference vector ;
     . searching into said distance table the closest distance to said computed current vector distance (d), and deriving therefrom the corresponding reordered codebook address of the closest vector therein, based on the so-called triangular inequality test.

2. A vector quantizing method according to claim 2, wherein said sampled signal is an audio signal.

3. A vector quantizing method according to claim 1, wherein said sampled signal is a video signal.

4. A vector quantizing method according to any one of claim 1 through 3, wherein said computing Euclidian distances ($d_i$) with respect to Vref, ordering said computed $d_i$'s into so-called distance table (T), and reordering said codebook, include :
   - computing :

$$d'_j = D\ (C'_j,\ Vref) = \Big(\sum_{k=1}^{N} (y_k - v_k)^2\Big)^{1/2}$$

wherein :

D stands for "distance" ;

$C'_j$ are the original codebook vectors ; (codewords) the components of which are N consecutive $Y_k$ ;

$v_k$ are the Vref vector components ;

$j = 1, 2, ..., S$, S being the codebook length ;

- ordering said computed distances in an increasing order to derive said T table

$$T = \{d_1, d_2, d_3, ..., d_S\}$$

$d_1, d_2, ...$ being the computed distances d' considered in an increasing order ;

- reordering the codewords according to said distance table, i.e. with respect to their relative distance to Vref.

**5.** A vector quantizing method according to claim 4, wherein said coding current vector X includes :
- computing the distance d of vector X relative to Vref ;
- locating d relative to the table T whereby $d_i$ is detected for providing

$$d_i < d < d_{i+1}$$

and deriving therefrom $C_i$ and $C_{i+1}$ locations into the reordered codebook ;
- searching for a left closest codeword $C_{i\text{-}Old_\ell}$ checking the so-called triangular inequality :

$$D(X, C_{i\text{-}Old_\ell}) + d_{i-\ell-1} < d$$

- searching for a right closest codeword $C_{(i+1)+Old_r}$ checking

$$D(X, C_{i+1+Old_r}) + d < d_{i+1+r+1}$$

- selecting as coding vector, the codeword $C_{i\text{-}Old_\ell}$ or $C_{i+1+Old_r}$, whichever is closest to X.

**6.** A vector quantizing method according to anyone of claims 1 through 5, wherein said reference vector Vref is equal to zero.

**7.** A vector quantizing method according to anyone of claims 1 through 5, wherein said reference vector Vref components $v_1 = v_2 = .... = v_n = Vmax$, wherein Vmax is the maximum numerical value allowable with the system being used.

**8.** A system using vector quantizing means for coding a sampled signal providing serial input signal samples, said system including :
- deserializing means (10) for deserializing N input signal samples into a vector X ;
- vector quantizing means (20) connected to said deserializing means (10), said quantizing means including :
  . a reordered codebook (22) including predefined codewords ordered according to their distance with respect to a predefined reference vector Vref ;
  . logic means (24) connected to said codebook and to Said deserializing means for selecting as coding vector the reordered codeword closest to X.

**9.** A system for coding a sampled signal according to claim 8, wherein said logic means (24) include :
- a distance table (T) storing the individual distances of the codewords relative to Vref, in an increasing order ;
- distance computing means connected to said deserializer (10) and to said distance table for computing the distance d of X relative to Vref and for locating d relative to the distance table contents

$$d_i < d < d_{i+1}$$

- selecting means connected to said distance computing means for deriving $C_i$ and $C_{i+1}$ corresponding to $d_i$ and $d_{i+1}$ respectively ;
- searching means connected to said selecting means for searching the left and right closest codeword $C_{i\text{-}Old_\ell}$ and $C_{i+1+Old_r}$ respectively checking the so-called triangular inequalities

  $D\ (X,\ C_{i\text{-}Old_\ell}) + d_{i-\ell-1} < d,$
  $D\ (X,\ C_{i+1+Old_r}) + d < d_{i+1+r+1}$

- selecting means connected to said searching means for selecting as coding vector for X, the closest to X vector among $C_{i\text{-}Old_\ell}$ and $C_{i+1+Old_r}$.

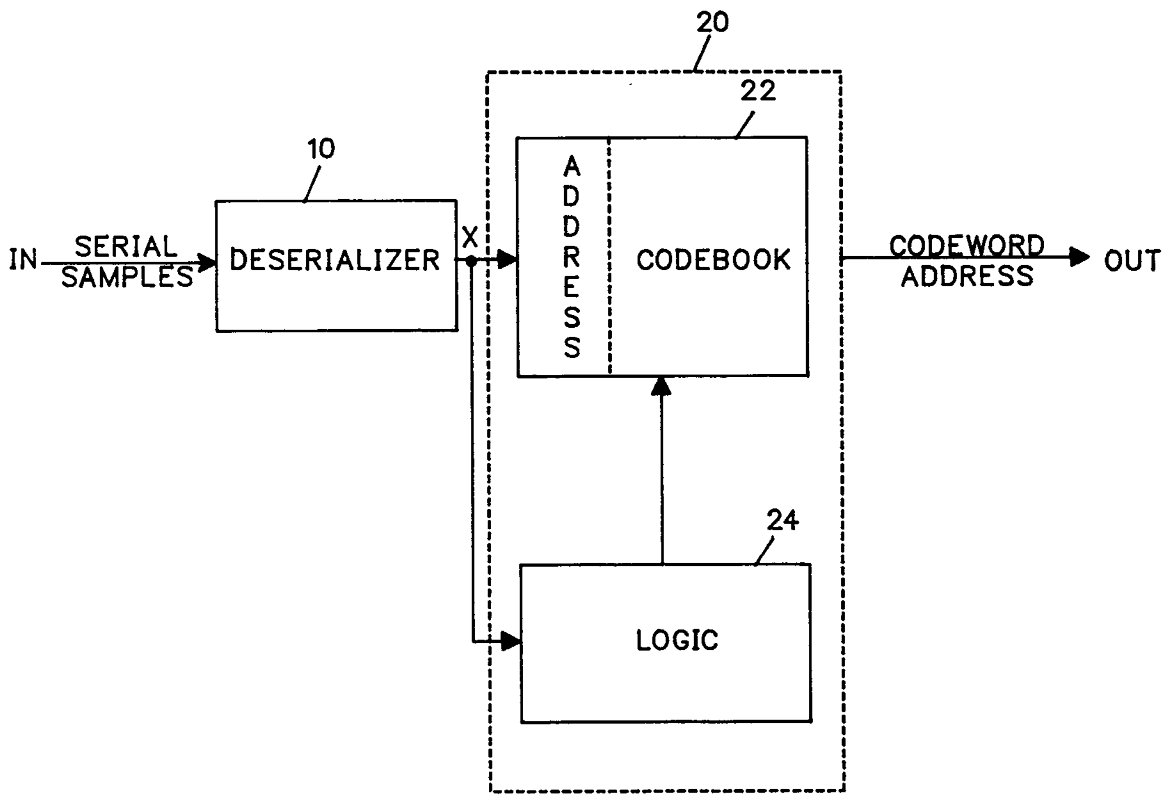
20
22
10
IN
SERIAL SAMPLES
DESERIALIZER
X
ADDRESS
CODEBOOK
CODEWORD ADDRESS
OUT
24
LOGIC

FIG.1

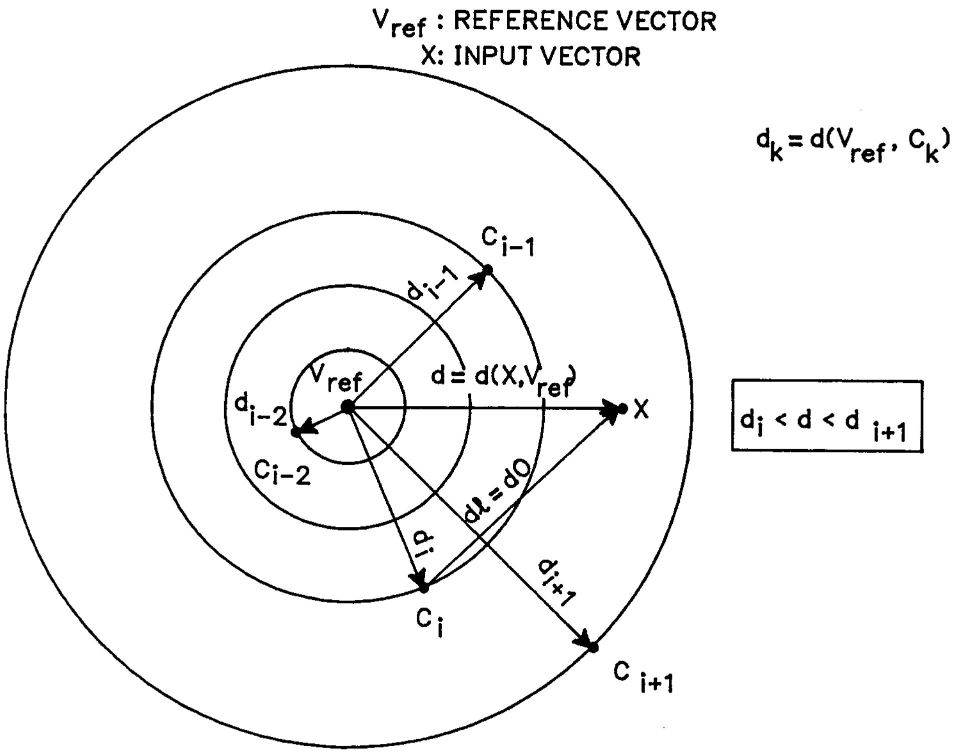
Vref : REFERENCE VECTOR
X: INPUT VECTOR
dk = d(Vref, Ck)
Ci-1
di-1
Vref
d = d(X,Vref)
X
di < d < d i+1
di-2
Ci-2
dl = dO
di
di+1
Ci
C i+1

FIG.2

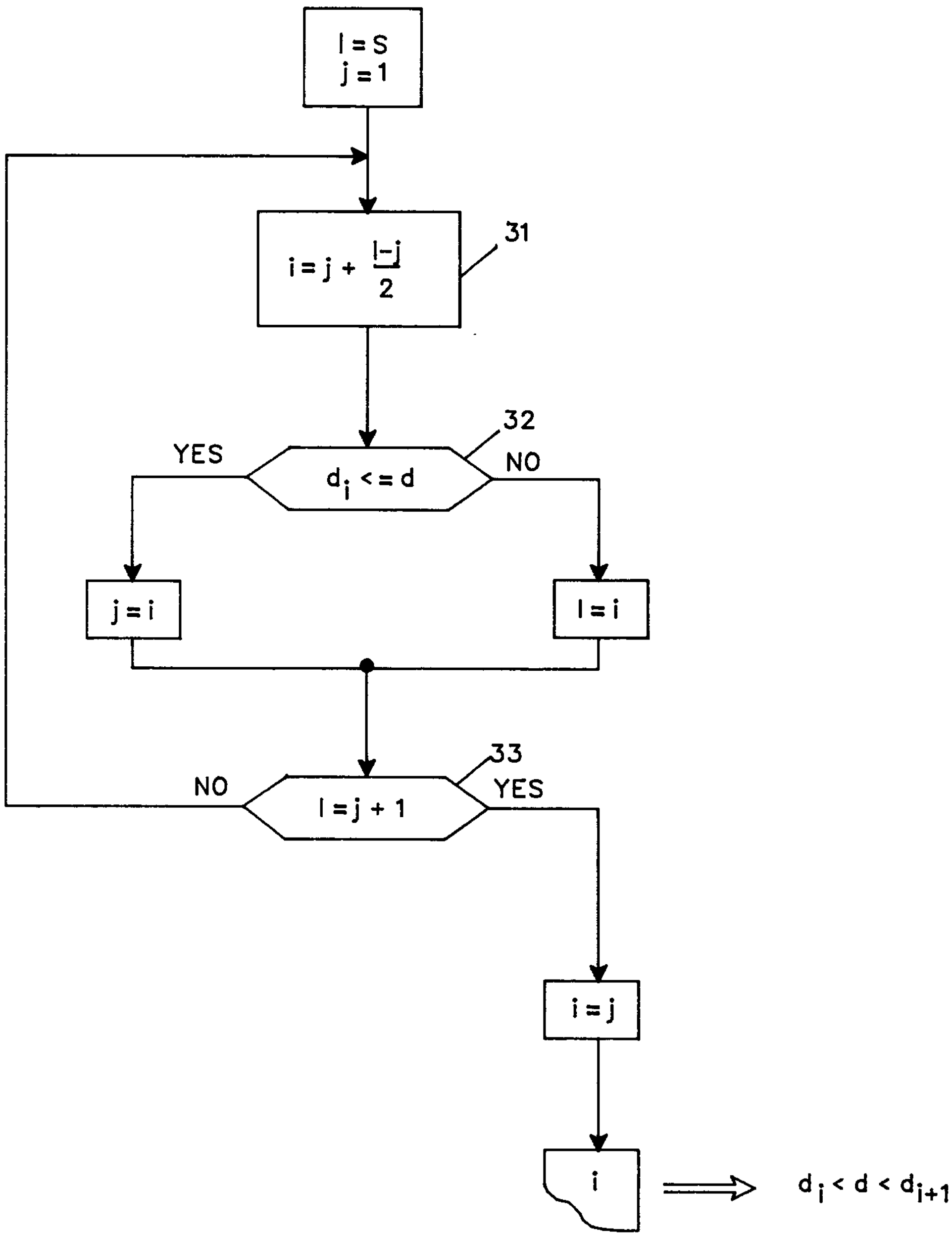


FIG.3

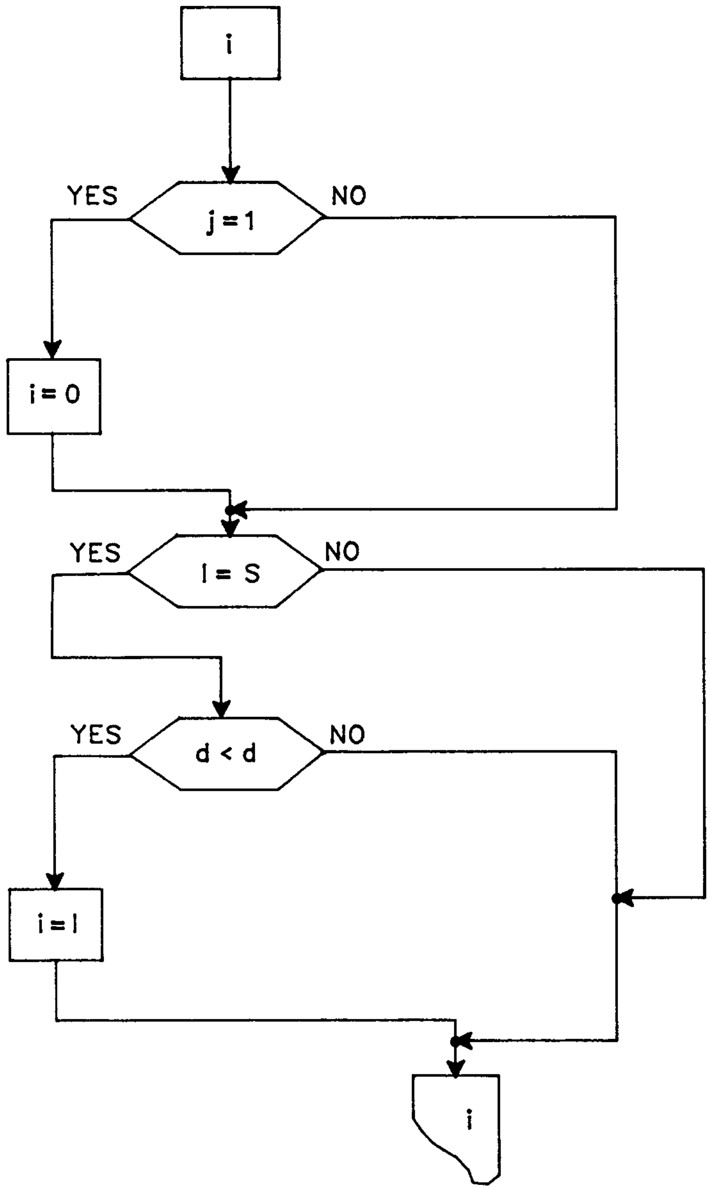


FIG.3A

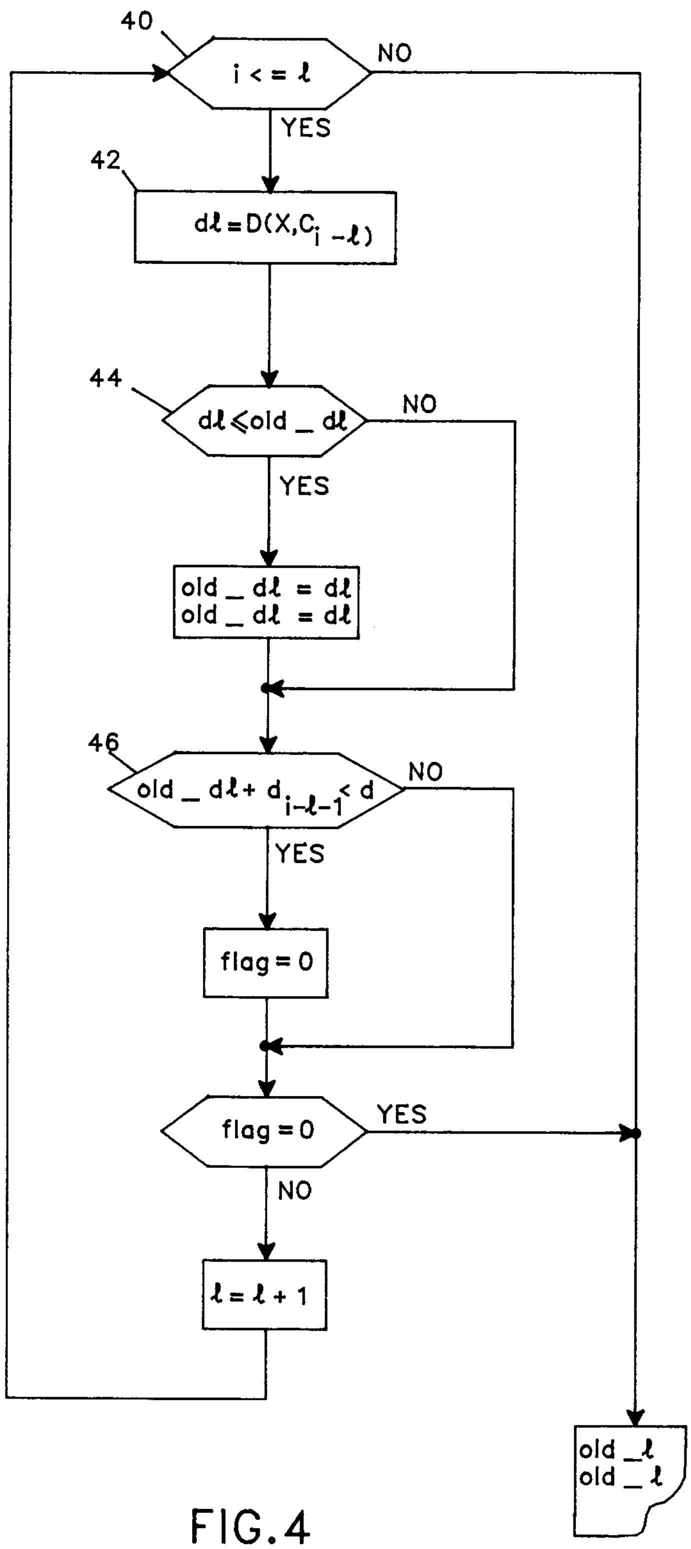
40
i < = ℓ
NO
YES
42
dℓ = D(X,C i −ℓ)
44
dℓ ⩽ old _ dℓ
NO
YES
old _ dℓ = dℓ
old _ dℓ = dℓ
46
old _ dℓ + d i−ℓ−1 < d
NO
YES
flag = 0
flag = 0
YES
NO
ℓ = ℓ + 1
old _ ℓ
old _ ℓ

FIG.4

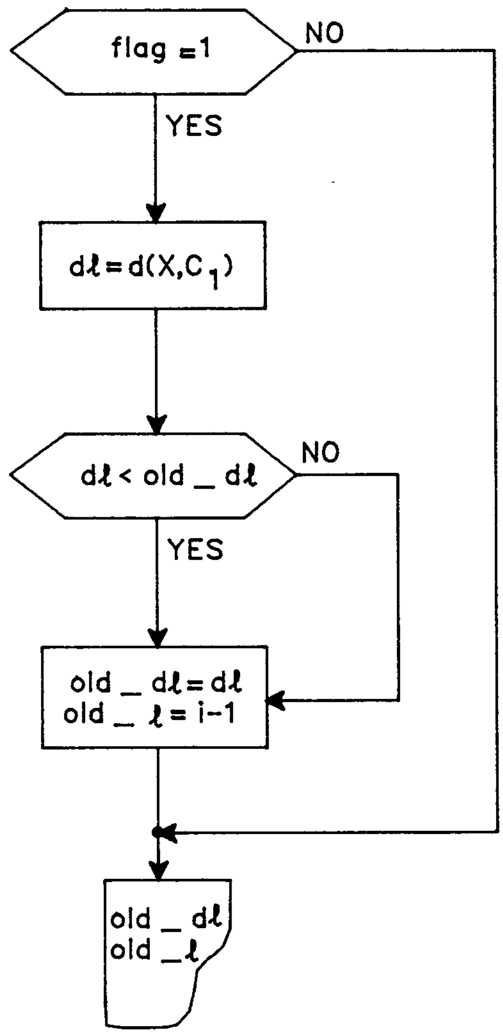
flag =1
NO
YES
dℓ=d(X,C1)
dℓ< old _ dℓ
NO
YES
old _ dℓ=dℓ
old _ ℓ= i-1
old _ dℓ
old _ ℓ

FIG.4A

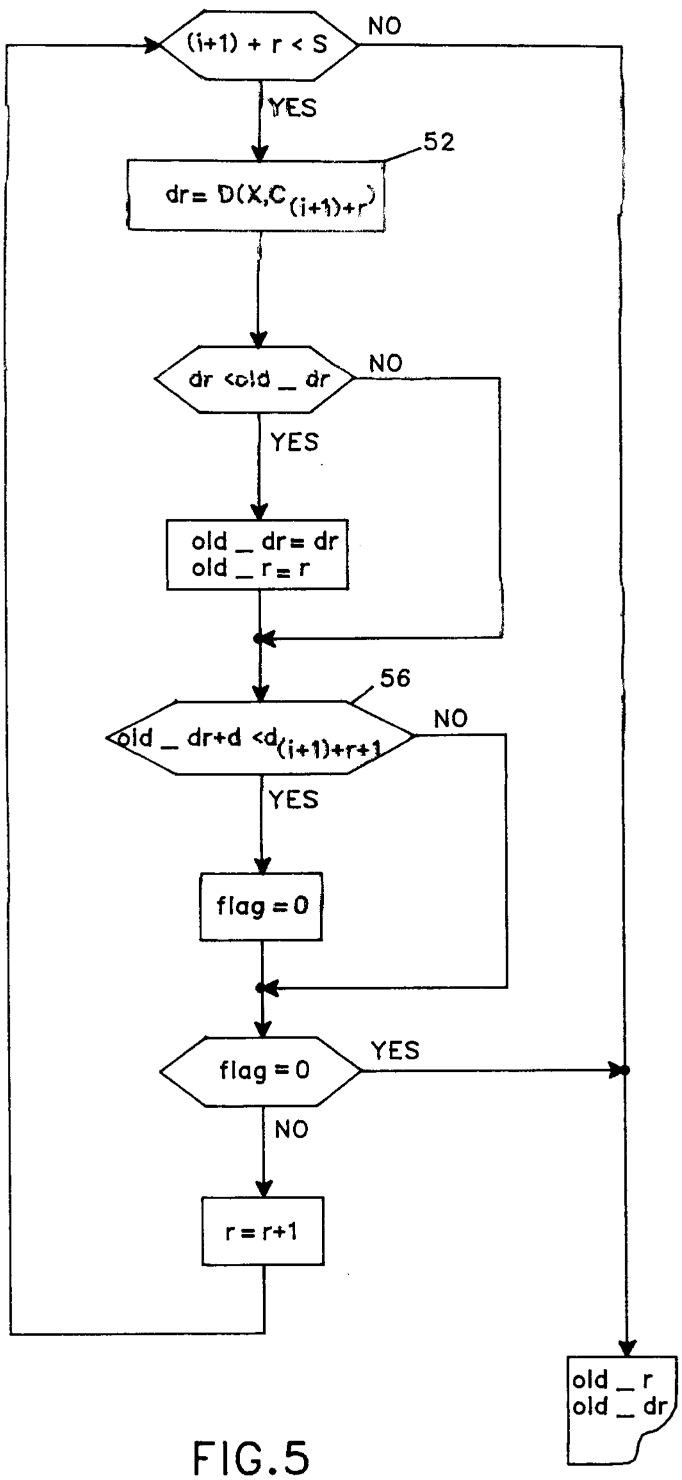
(i+1) + r < S
NO
YES
52
dr= D(X,C(i+1)+r)
dr <old _ dr
NO
YES
old _ dr= dr
old _ r = r
56
old _ dr+d <d(i+1)+r+1
NO
YES
flag = 0
flag = 0
YES
NO
r = r+1
old _ r
old _ dr

FIG.5

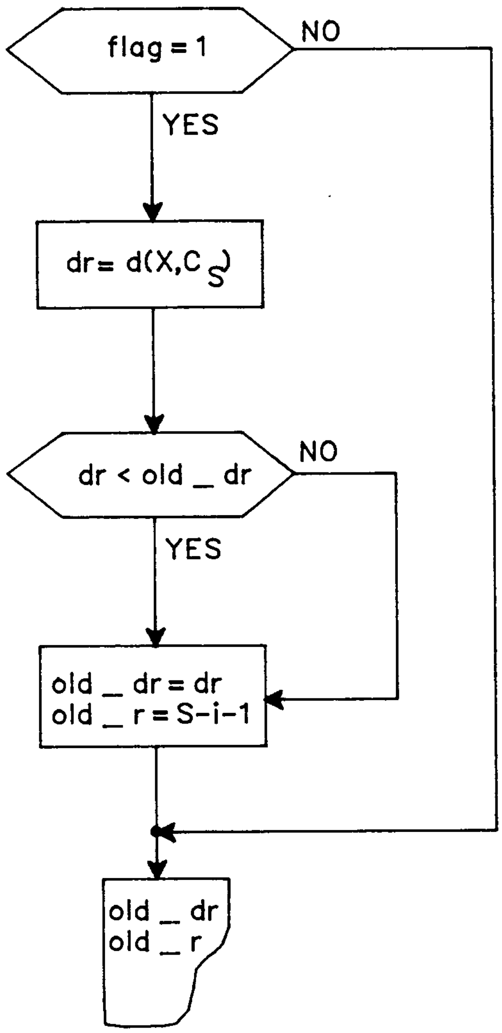
flag = 1
NO
YES
dr= d(X,C S)
dr < old _ dr
NO
YES
old _ dr = dr
old _ r = S-i-1
old _ dr
old _ r

FIG.5A

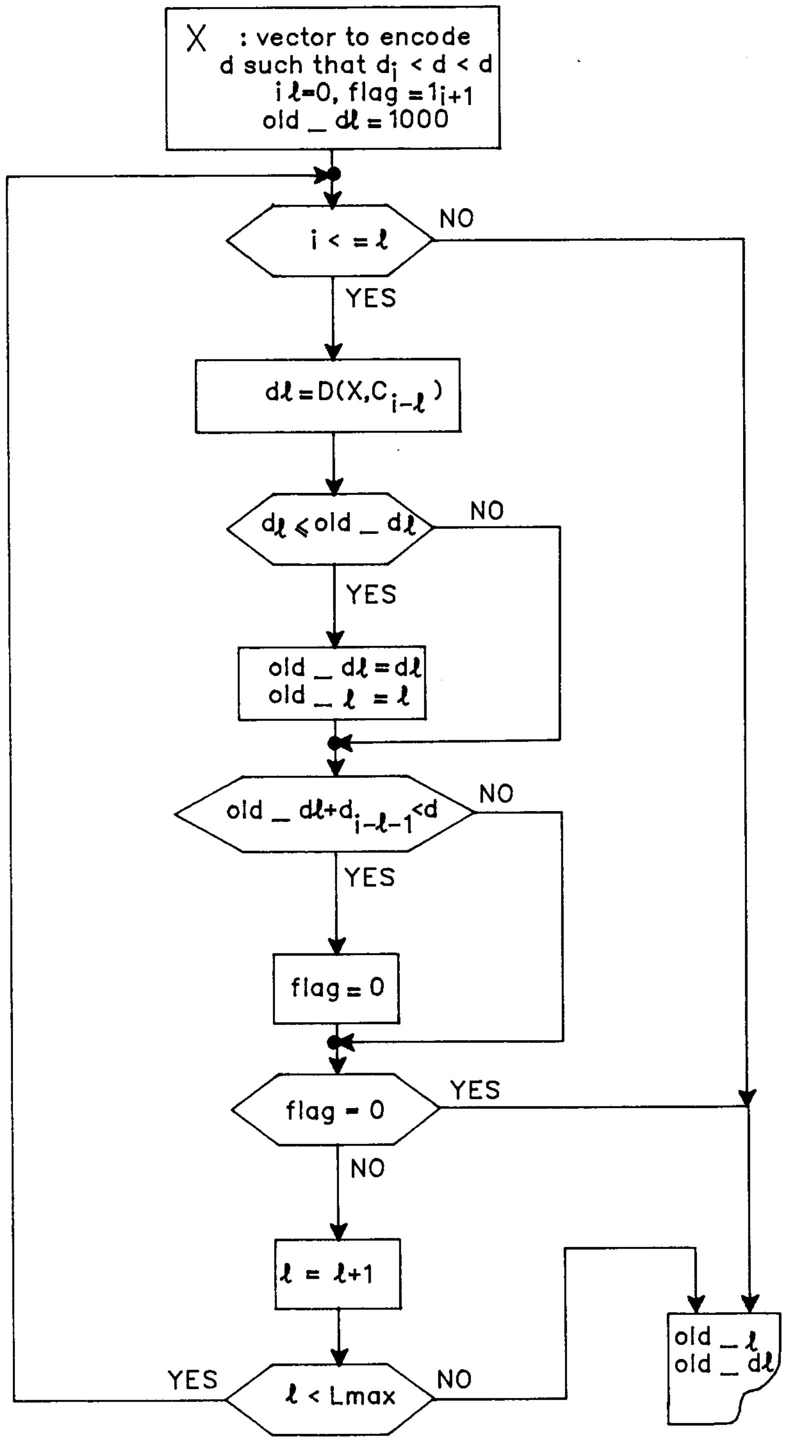
X : vector to encode
d such that di < d < d
i ℓ=0, flag =1i+1
old _ dℓ = 1000
i < = ℓ
NO
YES
dℓ = D(X,Ci-ℓ)
dℓ ≤ old _ dℓ
NO
YES
old _ dℓ = dℓ
old _ ℓ = ℓ
old _ dℓ+di-ℓ-1<d
NO
YES
flag = 0
flag = 0
YES
NO
ℓ = ℓ+1
YES
ℓ < Lmax
NO
old _ ℓ
old _ dℓ

FIG.6

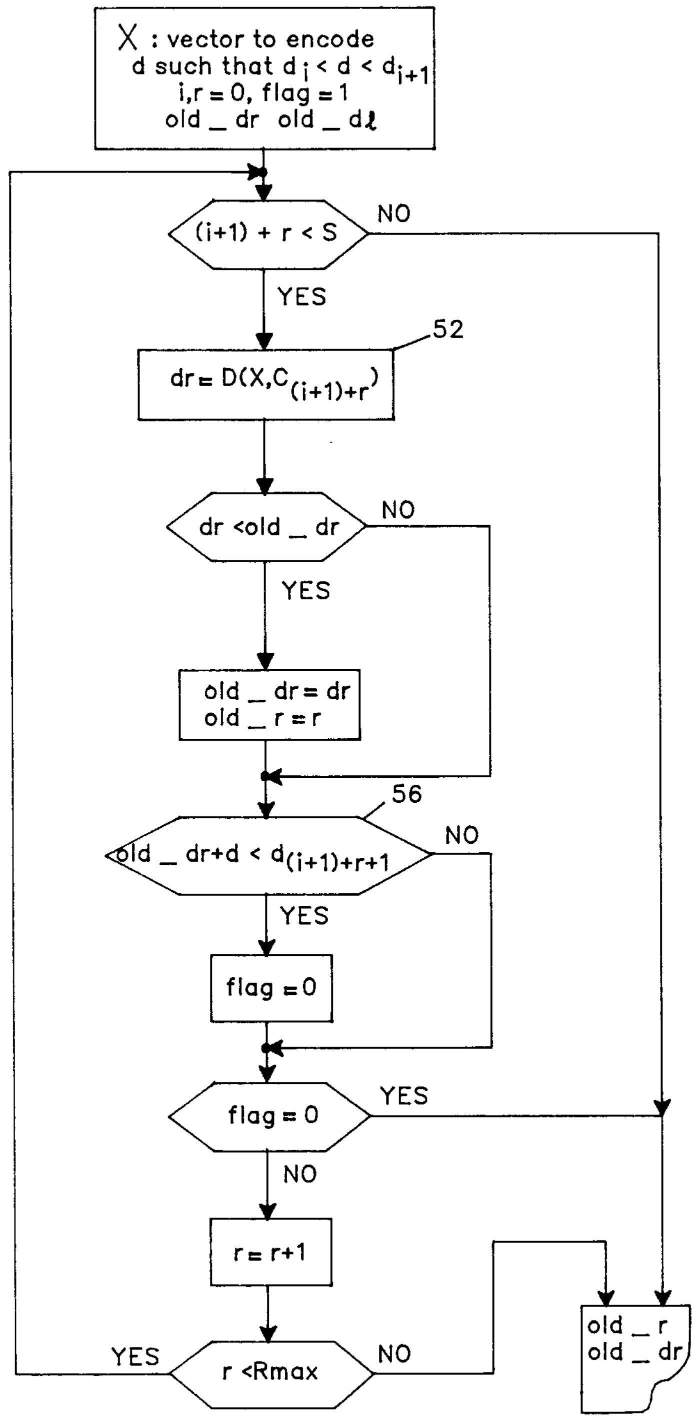
X : vector to encode
d such that $d_i < d < d_{i+1}$
i,r = 0, flag = 1
old _ dr old _ dℓ
(i+1) + r < S
NO
YES
52
dr = D(X,$C_{(i+1)+r}$)
dr <old _ dr
NO
YES
old _ dr = dr
old _ r = r
56
old _ dr+d < $d_{(i+1)+r+1}$
NO
YES
flag = 0
flag = 0
YES
NO
r = r+1
YES
r <Rmax
NO
old _ r
old _ dr

FIG.7

European Patent Office

# EUROPEAN SEARCH REPORT

Application Number

EP 91 48 0054

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | WO-A-9 015 485 (UTAH STATE UNIVERSITY FOUNDATION ) 7 June 1990<br>* page 11, line 33 - page 19, line 14; figures 3-8 *<br>----- | 1-4,8 | H03M7/30 |

| TECHNICAL FIELDS SEARCHED (Int. Cl.5 ) |
|---|
| H03M<br>G10L<br>H04N |

The present search report has been drawn up for all claims

| Place of search | Date of completion of the search | Examiner |
|---|---|---|
| THE HAGUE | 26 NOVEMBER 1991 | AUGARDE E.P.G.T. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document